Europäisches Patentamt

European Patent Office

Office européen des brevets

(19)

(11) EP 0 699 359 B1

# (12) FASCICULE DE BREVET EUROPEEN

(45) Date de publication et mention
de la délivrance du brevet:
**14.01.1998 Bulletin 1998/03**

(21) Numéro de dépôt: **94917044.3**

(22) Date de dépôt: **20.05.1994**

(51) Int Cl.⁶: **H03F 3/343**, H03H 11/46,
H03G 1/00

(86) Numéro de dépôt international:
**PCT/FR94/00604**

(87) Numéro de publication internationale:
**WO 94/28626 (08.12.1994 Gazette 1994/27)**

(54) **CIRCUIT ELECTRONIQUE, NOTAMMENT RESISTANCE REGLABLE, RESISTANCE NEGATIVE, OU FILTRE OU ANALOGUE, COMMANDES PAR UN COURANT DE POLARISATION**

VORSPANNUNGSSTROMGESTEUERTE ELEKTRONISCHE SCHALTUNG, INSBESONDERE EINSTELLBARER WIDERSTAND, NEGATIVER WIDERSTAND, ODER FILTER ODER DERGLEICHEN

POLARIZATION CURRENT CONTROLLED ELECTRONIC CIRCUIT SUCH AS AN ADJUSTABLE RESISTANCE, A NEGATIVE RESISTANCE OR A FILTER OR SIMILAR

(84) Etats contractants désignés:
DE FR GB IT

(30) Priorité: **21.05.1993 FR 9306121**

(43) Date de publication de la demande:
**06.03.1996 Bulletin 1996/10**

(73) Titulaire: **UNITES CONCEPTION ET INTEGRATIONS EN MICROELECTRONIQUE**
**F-91120 Palaiseau (FR)**

(72) Inventeurs:
• **WIEST, Francis**
**F-78114 Magny (FR)**
• **FABRE, Alain**
**F-92160 Antony (FR)**

(74) Mandataire: **Derambure, Christian et al**
**Bouju Derambure Bugnion**
**52, rue de Monceau**
**75008 Paris (FR)**

(56) Documents cités:
**EP-A- 0 454 253**

• ELECTRONICS LETTERS., vol.24, no.9, 28 Avril 1988, ENAGE GB pages 548 - 549 A. FABRE 'TRANSLINEAR CURRENT-CONTROLLED CURRENT AMPLIFIER'
• ELECTRONICS LETTERS., vol.20, no.17, 16 Octobre 1984, ENAGE GB pages 674 - 676 A. FABRE ET AL 'ULTRA-LOW-DISTORTION CURRENT-CONVERSION TECHNIQUE'
• INTERNATIONAL JOURNAL OF ELECTRONICS, vol.65, no.6, Décembre 1988, LONDON GB pages 1203 - 1208 W. SURAKAMPONTORN ET AL 'DUAL TRANSLINEAR SINUSOIDAL FREQUENCY DOUBLER AND FULL-WAVE RECTIFIER'
• IEEE TRANSACTIONS ON CIRCUITS AND SYSTEMS, vol.39, no.2, Février 1992, NEW YORK US pages 152 - 155 A. FABRE ET AL 'INSENSITIVE CURRENT-MODE BANDPASS IMPLEMENTATIONS-BASED NONIDEAL GYRATORS'

## Description

La présente invention concerne des circuits électroniques comprenant au moins un convoyeur de courant de deuxième génération constitué par une boucle translinéaire mixte et une pluralité de miroirs de courant. Comme il est connu dans l'art, un tel convoyeur présente un port d'entrée, un port de sortie et un port de référence à haute impédance.

Les convoyeurs de courant de deuxième génération sont bien connus dans l'art de la micro-électronique notamment pour la réalisation de circuits intégrés. On sait qu'ils sont généralement utilisés pour leur qualité de modification d'impédance. En effet, un courant appliqué au port d'entrée apparaît à l'identique sur le port de sortie dans le cas d'un convoyeur de courant de deuxième génération positif (CCII+ dans la suite), ou inversé dans le cas d'un convoyeur de courant de deuxième génération négatif (CCII- dans la suite), le port de sortie présentant une impédance différente de celle du port d'entrée. Le port de référence présente une impédance extrêmement élevée et constitue donc une référence en tension.

De nombreux documents décrivent de tels convoyeurs. A titre d'exemples, US-A-3 619 798, US-A-3 582 689, EP-A-0 383 397 décrivent de tels convoyeurs de courant.

Tous les documents précités proposent des améliorations sensibles aux convoyeurs de courant, mais n'entrent pas vraiment dans le domaine des applications de ces convoyeurs.

D'autres documents tels que INTERNATIONAL JOURNAL OF ELECTRONICS, volume 65, n° 6, décembre 1988, pages 1203 à 1208, et IEEE TRANSACTIONS ON CIRCUITS AND SYSTEMS, volume 39, n° 2, février 1992, concernent des circuits électroniques comprenant des convoyeurs de courant et dont le but est d'amplifier des courants.

Le document US-A-5 124 666 concerne un convoyeur de courant de la deuxième génération approprié pour une technologie de circuits intégrés en MOS, destiné à réaliser des filtres passe-bande et différents filtres présentant des fonctions de transfert du deuxième ordre sans mettre en oeuvre d'amplificateurs opérationnels.

Le document "Electronics letters", volume 24, n° 9 du 28.04.1988, pages 548 à 549 concerne un convoyeur de courant dont le gain peut être commandé en fonction du courant de polarisation.

Le document EP-A-0 454 253 concerne un amplificateur de courant comprenant un convoyeur de courant dans lequel notamment les sources de courant de polarisation peuvent être variables.

Enfin le document "Electronics letters", volume 20, n° 17 du 16.10.1984, pages 674 à 676 décrit un circuit électronique comportant au moins un convoyeur de courant dont le rapport entre le signal de sortie et le signal d'entrée est commandé par un courant de polarisation.

Or, il existe une demande de réalisation de circuits électroniques simples mettant en oeuvre un ou plusieurs convoyeurs de courant permettant d'obtenir une intégration maximale de ces circuits.

Un premier but de la présente invention telle que définie dans les revendications est de réaliser des circuits électroniques comportant des convoyeurs de courant et dont les caractéristiques sont réglables en fonction de paramètres simples, par exemple les courants de polarisation des convoyeurs.

En particulier, il s'avère difficile de réaliser une résistance réglable dans un circuit intégré car une telle résistance réglable ne peut pas être contrôlée de façon précise jusqu'à ce jour.

Un autre but de la présente invention est donc la réalisation d'une résistance réglable qui puisse être contrôlée de façon précise à partir d'un paramètre simple et avec un encombrement minimal.

Un autre but de la présente invention est d'utiliser comme résistance réglable, une résistance intrinsèque induite par la conception du convoyeur de courant et dont l'art antérieur enseigne qu'elle parasite le bon fonctionnement du convoyeur et qu'à cet égard, il convient de la minimiser.

Un convoyeur de courant présente un port d'entrée (X), un port de sortie (Z) et un port de référence (Y). Le convoyeur est polarisé par un courant de polarisation (I). Comme il est connu également, le port de sortie (Z) recopie le courant appliqué sur le port d'entrée (X) de manière que l'on ait : $I_z = I_x$ (CCII+) ou $I_z = -I_x$ (CCII-).

L'invention a aussi pour objet un circuit électronique comprenant au moins un premier convoyeur de courant de deuxième génération constitué par une boucle translinéaire mixte et une pluralité de miroirs de courant, ledit convoyeur présentant un port de référence à haute impédance, un port d'entrée ayant une résistance intrinsèque équivalente à la résistance de sortie du générateur de Thévenin équivalent vu par ledit port d'entrée, et étant polarisé par un courant de polarisation, un port de sortie dont le courant correspond à celui du port d'entrée, et des moyens de commande de l'intensité du courant de polarisation, pour déterminer la valeur ohmique de la résistance intrinsèque.

Selon un premier aspect, l'invention concerne un circuit électronique tel que décrit ci-dessus, dont les ports de référence et de sortie du convoyeur sont directement reliés entre eux. Le circuit électronique constitue alors une résistance réglable négative dans le cas d'un convoyeur de type CCII(-) et positive dans le cas d'un convoyeur de type CCII(+).

Selon un deuxième aspect, l'invention concerne un circuit électronique tel que décrit ci-dessus, dont au moins un des ports du convoyeur est relié à la masse

Selon un troisième aspect, l'invention a également pour objet un amplificateur de courant à gain contrôlable mettant en oeuvre un convoyeur de courant formant résistance tel qu'indiqué précédemment. Selon l'invention, le premier convoyeur est disposé comme précédemment indiqué de manière à constituer une résistance réglable, le port de référence étant relié à la masse. Le port d'entrée de ce premier convoyeur est connecté à une source de courant et au port de référence d'un deuxième convoyeur de courant de deuxième génération similaire au premier, dont le port d'entrée est relié à la masse de telle manière que le courant sur le port de sortie du deuxième convoyeur soit égal au courant délivré par la source de courant multiplié par un coefficient multiplicateur fonction du rapport des courants de polarisation de chacun des convoyeurs. L'amplificateur qui vient d'être décrit devient immédiatement un mélangeur, dès lors que le courant de polarisation du deuxième convoyeur et le courant délivré par la source de courant précitée sont des courants alternatifs.

Selon un quatrième aspect, l'invention a également pour objet un amplificateur de tension à gain contrôlable mettant en oeuvre un convoyeur de courant formant résistance tel qu'indiqué précédemment. Selon l'invention, le port d'entrée du premier convoyeur est relié à la masse, le port de référence est connecté à une source et le port de sortie est connecté au premier port d'entrée d'un deuxième convoyeur de courant de la deuxième génération comprenant un port de référence relié à la masse, un deuxième port d'entrée copiant la tension d'entrée du port d'entrée de telle manière que la tension sur les premier et deuxième ports d'entrée du deuxième convoyeur soit égale à la tension délivrée par la source de tension multipliée par un coefficient fonction du rapport des courants de polarisation de chacun desdits convoyeurs.

Selon un autre aspect, l'invention a pour objet un circuit de simulation de self comportant deux convoyeurs de deuxième génération de même type que le premier convoyeur décrit.

Le circuit de simulation de self a pour particularité de pouvoir être réglé par modification d'au moins un des courants de polarisation appliqués aux dits convoyeurs.

Le circuit de simulation de self comporte une borne d'entrée, une autre borne de mise à la masse, en outre, un deuxième et un troisième convoyeurs de courant de deuxième génération constitués par respectivement une boucle translinéaire mixte et une pluralité de miroirs de courant, les convoyeurs présentant respectivement un port de référence à haute impédance, un port d'entrée ayant une résistance intrinsèque équivalente à la résistance de sortie du générateur de Thévenin équivalent, vu par le port d'entrée, et étant polarisé respectivement par un courant de polarisation, et un port de sortie dont le courant correspond à celui du port d'entrée, et des moyens de commande de l'intensité des courants de polarisation pour déterminer la valeur ohmique de ladite résistance intrinsèque, l'un quelconque des ports d'entrée ou de référence du deuxième convoyeur étant relié, d'une part à une borne d'une capacité dont l'autre borne est reliée à la masse, et d'autre part, à l'un quelconque des ports d'entrée ou de sortie du troisième convoyeur, et la borne d'entrée du circuit de simulation de self étant constitué par le point de connexion entre l'un quelconque des ports d'entrée ou de sortie du deuxième convoyeur et l'un quelconque des ports d'entrée ou de référence du troisième convoyeur.

Selon un dernier aspect, l'invention concerne un filtre passe-bande réglable mettant en oeuvre une résistance telle que précédemment indiquée ainsi qu'une pluralité de convoyeurs de courant de deuxième génération sensiblement identiques entre eux, le premier convoyeur utilisé étant connecté en résistance négative, telle que décrite précédemment. Selon l'invention, les ports de sortie et de référence de ce premier convoyeur sont reliés à la masse par l'intermédiaire d'un premier condensateur, tandis que son port d'entrée est relié à la masse ; ce circuit comprend, en outre, un circuit de simulation de self, tel que décrit précédemment, dont l'entrée est reliée, d'une part au point de connexion entre le premier condensateur et les ports de sortie et de référence du premier convoyeur, et d'autre part à une borne d'une résistance, de manière à réaliser ainsi un filtre passe-bande dont les caractéristiques sont réglables par modification d'au moins un des courants de polarisation appliqués aux dits convoyeurs.

Selon un premier aspect, le filtre passe-bande décrit ci-dessus est en mode tension : l'entrée du circuit est constituée par la borne libre de la résistance à laquelle est appliquée une tension d'entrée, tandis que la sortie du circuit est constituée par le port de référence du premier convoyeur sur lequel est prélevée une tension de sortie.

Selon un deuxième aspect, le filtre passe-bande décrit ci-dessus est en mode courant : l'entrée du circuit est constituée par le port de référence du premier convoyeur auquel est appliqué un courant d'entrée, et la sortie du circuit est constituée par la borne libre de la résistance sur laquelle est prélevé un courant de sortie.

Ce filtre passe-bande en mode courant peut comporter en outre un quatrième convoyeur de courant de deuxième génération de même type que le premier convoyeur, dont le port d'entrée est relié à la borne libre de la résistance, le port de référence est relié à la masse, la sortie du circuit étant constituée par le port de sortie dudit quatrième convoyeur sur lequel est prélevé un courant de sortie, tandis que l'entrée du circuit est constituée par le port d'entrée du premier convoyeur auquel est appliqué un courant d'entrée. Ce quatrième convoyeur sert principalement à effectuer une adaptation d'impédance en sortie du filtre passe-bande en mode courant.

L'invention sera mieux comprise et d'autres buts, avantages et caractéristiques de celle-ci apparaîtront plus clairement à la lecture de la description qui suit des modes préférés de réalisation donnés à titre non limitatif, et à laquelle trois planches de dessins sont jointes sur lesquelles :

- la figure 1 représente schématiquement un convoyeur de courant de deuxième génération positif (CCII+) connu tel que mis en oeuvre dans la présente invention ;

- la figure 2 représente schématiquement un convoyeur de courant de deuxième génération négatif (CCII-) connu tel que mis en oeuvre dans la présente invention ;
- la figure 3 représente schématiquement un circuit électrique mettant en oeuvre le convoyeur de courant de la figure 1 pour réaliser une résistance réglable ;
- la figure 4 représente schématiquement un circuit électrique comprenant deux convoyeurs de courant connectés de manière à constituer un amplificateur de courant à gain contrôlable ;
- la figure 5 représente schématiquement un circuit électrique comprenant deux convoyeurs de courant connectés de manière à constituer un amplificateur de tension à gain contrôlable ;
- la figure 6 représente un circuit électronique formant circuit de simulation de self selon l'invention ;
- la figure 7 représente schématiquement un circuit électronique comprenant trois convoyeurs de courant et constituant un filtre passe-bande réglable;
- la figure 8 représente schématiquement un circuit électronique comprenant quatre convoyeurs de courant et constituant un filtre passe-bande réglable en mode courant.

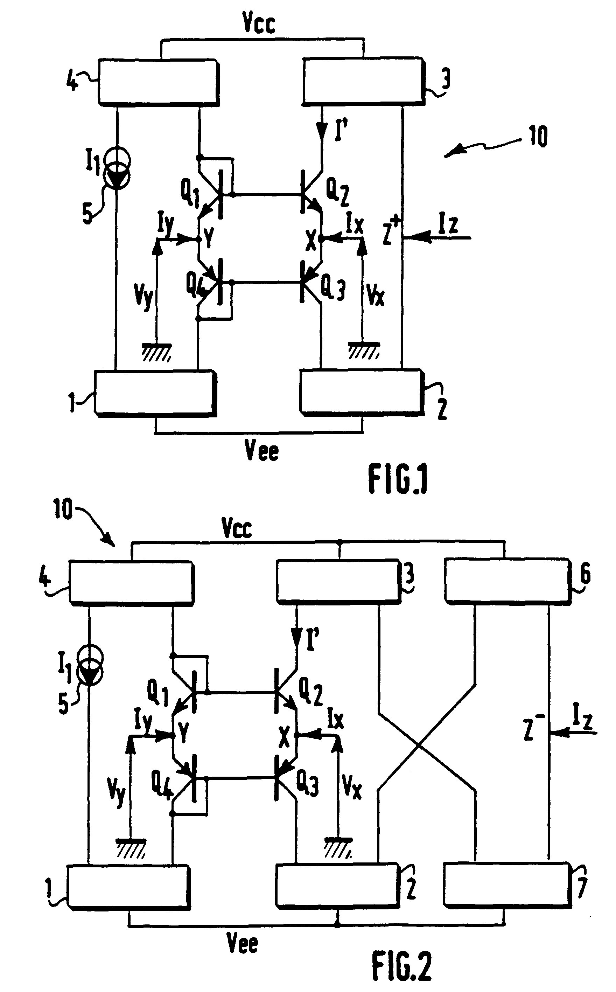

En référence maintenant aux figures, la figure 1 représente schématiquement un convoyeur de courant de deuxième génération positif (CCII+) tel qu'il est connu dans l'art. Un tel convoyeur comporte quatre miroirs de courant référencés 1, 2, 3 et 4, et une boucle translinéaire mixte. La boucle est réalisée de façon connue au moyen de quatre transistors Q1, Q2, Q3 et Q4 dont deux, Q1 et Q4, ont leur jonction base-collecteur court-circuitée de manière à constituer des diodes. Ce mode de réalisation présente notamment l'avantage d'obtenir des caractéristiques identiques pour les diodes et les jonctions base-émetteur des transistors. La polarisation du convoyeur est obtenue au moyen d'une source de courant 5. Le convoyeur présente un port d'entrée X recevant un courant $I_x$ sous une tension $V_x$. Un courant $I_z$ égal au courant $I_x$ est généré sur le port de sortie $Z^+$. Le port Y est un port de référence qui fait fonction de définition de potentiel puisqu'il présente une impédance d'entrée extrêmement élevée, le courant $I_y$ appliqué à ce port étant sensiblement nul.

La figure 2 représente schématiquement un convoyeur de courant de deuxième génération négatif (CCII-) tel qu'il est connu dans l'art. Par rapport au CCII+ précédent, le CCII- comporte deux miroirs supplémentaires 6, 7 de telle sorte que le convoyeur présentant un port d'entrée X recevant un courant $I_x$ sous une tension $V_x$, un courant $I_z$ inverse du courant $I_x$ est généré sur le port de sortie $Z^-$.

Les convoyeurs de courant de la deuxième génération ne seront pas décrits plus en détail ici car ils sont considérés comme connus en tant que tels par l'homme du métier qui au besoin pourra se rapporter aux documents cités ci-avant pour en connaître le fonctionnement et d'autres détails techniques.

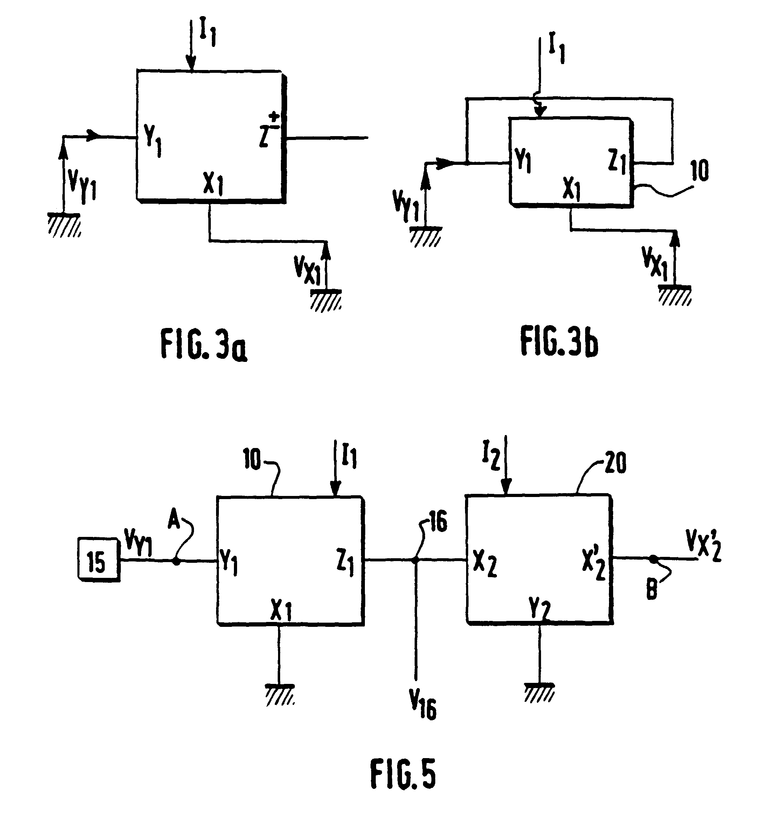

En référence maintenant aux figures 3a, 3b, les convoyeurs de courant ont été représentés sous forme de schéma bloc de manière à simplifier les figures. De même chaque figure peut représenter un CCII+ ou un CCII-. Comme on peut le constater :

$$V_{X1} = V_{Y1} + R \cdot I_X.$$

La résistance R apparaissant sur $X_1$ est équivalente à la résistance de sortie du générateur de Thevenin vu de $X_1$. La résistance R est équivalente aux résistances de sortie des émetteurs des transistors $Q_2$ et $Q_3$ mises en parallèle. En première approximation, R est donnée par la relation

$$R \# V_T/2I'$$

avec $V_T$ potentiel thermodynamique (par exemple 26mV à 27°C) et où I' est le courant de polarisation des transistors Q2, Q3 et est fonction de $I_1$ courant de polarisation du convoyeur. Cette résistance R est donc inversement proportionnelle au courant de polarisation $I_1$ et est donc réglable au moyen de ce courant.

Dans le cas de la figure 3a, en regardant le circuit par l'entrée $X_1$ vers $Y_1$, on observe que quel que soit le convoyeur CCII+ ou CCII-, la résistance R, dont la valeur ohmique est fonction de $I_1$, sera positive.

Dans le cas de la figure 3b où la sortie $Z_1$ est bouclée sur la référence $Y_1$ et en regardant le circuit par la borne commune $Y_1 + Z_1$ vers $X_1$, on observe qu'avec un CCII+, on obtient une résistance négative R, dont la valeur ohmique est fonction de $I_1$, et qu'avec un CCII-, on obtient une résistance positive R, dont la valeur ohmique est fonction de $I_1$.

On peut également référencer cette résistance par rapport à la masse en reliant les ports de sortie $Z_1$ et de référence $Y_1$ directement à la masse, c'est-à-dire en rendant la tension $V_{Y1}$ égale à 0.

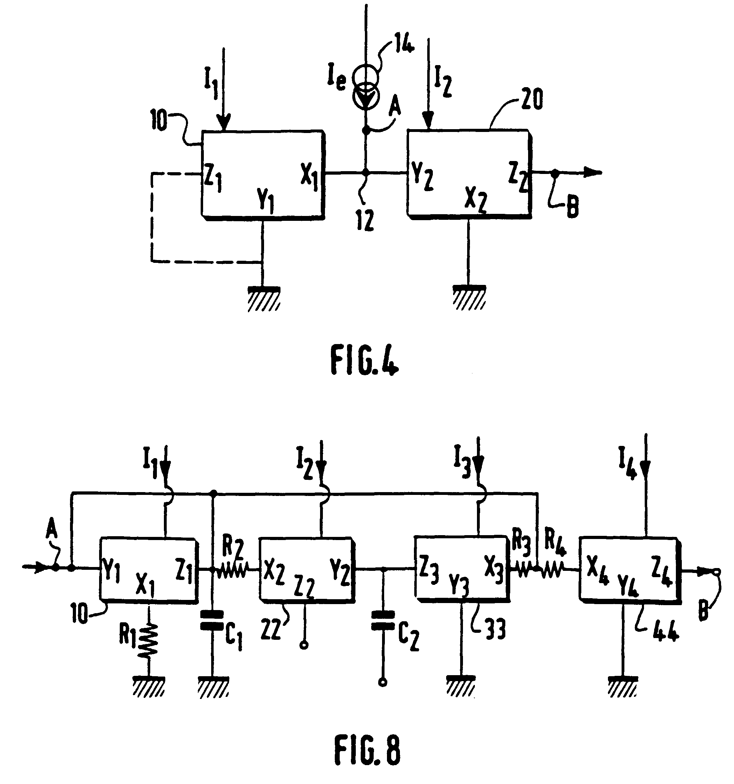

En référence maintenant à la figure 4, le convoyeur 10 est connecté conformément à l'enseignement qui a été décrit par rapport à la figure 3a, le port de référence $Y_1$ de ce premier convoyeur 10 étant relié à la masse. Il y a donc entre le port de référence $Y_1$ et le port d'entrée $X_1$ une résistance réglable au moyen du courant de polarisation $I_1$.

Sur cette figure 4, le port d'entrée $X_1$ du premier convoyeur 10 est relié au port de référence $Y_2$ d'un deuxième convoyeur 20. Le port d'entrée $X_2$ de ce deuxième convoyeur 20 est relié à la masse. Ce deuxième convoyeur 20 est polarisé par un courant de polarisation $I_2$. Le point de jonction du port d'entrée $X_1$ du premier convoyeur 10 et du port de référence $Y_2$ du deuxième convoyeur 20, référencé 12, est relié à un générateur de courant 14 générant un courant $I_e$. La tension au point de jonction 12 peut donc s'écrire $V = R_1 . I_e$. Or, le courant de sortie du circuit en $Z_2$ est égal à $V/R_2$ ; on obtient alors $I_{Z2} = I_e . R_1/R_2$. Comme on a vu que Ri est égal, en première approximation, au potentiel thermodynamique $V_T$ divisé par deux fois l'intensité du courant de polarisation des transistors constituant l'étage X, ce courant étant fonction du courant Ii de polarisation du convoyeur i, on obtient très simplement $I_{Z2} = I_e . I_2/I_1$. On constate donc que l'on obtient un amplificateur de courant dont le gain est fonction du rapport des courants de polarisation des deux convoyeurs 10 et 20.

Un tel amplificateur de courant à gain contrôlable peut être très facilement mis en oeuvre dans une boucle de contrôle automatique de gain. On peut également utiliser cet amplificateur en tant que mélangeur lorsque la source de courant 14 est une source de courant alternatif et que le courant de polarisation $I_2$ du deuxième convoyeur 20 est constitué par un courant continu auquel est ajouté un courant alternatif. En écrivant $I_2 = I_0 + I_{mod} \sin (W_{LO}t)$, et $I_e = I_i \sin (W_0t)$ on obtient en effet :

$$I_{Z2} = \frac{I_i I_0}{I_1} \sin(W_{0t}) + \frac{I_i I_{mod}}{2_{I1}} [\cos(W_0 - W_{20})t - \cos(W_0 + W_{20})t]$$

Dans une variante de réalisation de l'amplificateur de courant à gain contrôlable, les ports $Z_1$ et $Y_1$ peuvent être reliés ensemble tel que représenté en pointillé sur la figure 4.

En référence maintenant à la figure 5, le circuit électronique représenté constitue un amplificateur de tension à gain contrôlable. Sur cette figure 5, le port d'entrée $X_1$ du premier convoyeur 10 est relié à la masse, le port de référence $Y_1$ est connecté à une source de tension 15 et le port de sortie $Z_1$ est connecté au port d'entrée $X_2$ d'un deuxième convoyeur 20 de courant de deuxième génération . Ce deuxième convoyeur 20 comporte en outre un deuxième port d'entrée $X'_2$ copiant la tension du point de jonction 16. Le courant au port $Z_1$ peut s'écrire

$$I_{Z1} = V_{Y1} / R_1.$$

De même, on peut écrire que la tension $V_{16} = R_2.I_{Z1}$, d'où en combinant les deux formules on obtient :

$$V_{16} = (R_2 / R_1).V_{Y1}.$$

Comme cela a été précisé la tension $V_{16}$ au port d'entrée $X_2$ est recopiée selon un principe connu sur le port $X'_2$ d'où

$$V_{16} = V_{X'2} = (R_2 / R_1).V_{Y1}$$

Les deux résistances étant chacune fonction du courant de polarisation comme cela a été indiqué, on obtient :

$$V_{16} = V_{X'2} = (I_1 / I_2).V_{Y1}$$

Le circuit est donc un amplificateur de tension dont le gain est fonction du rapport des courants de polarisation des deux convoyeurs 10 et 20.

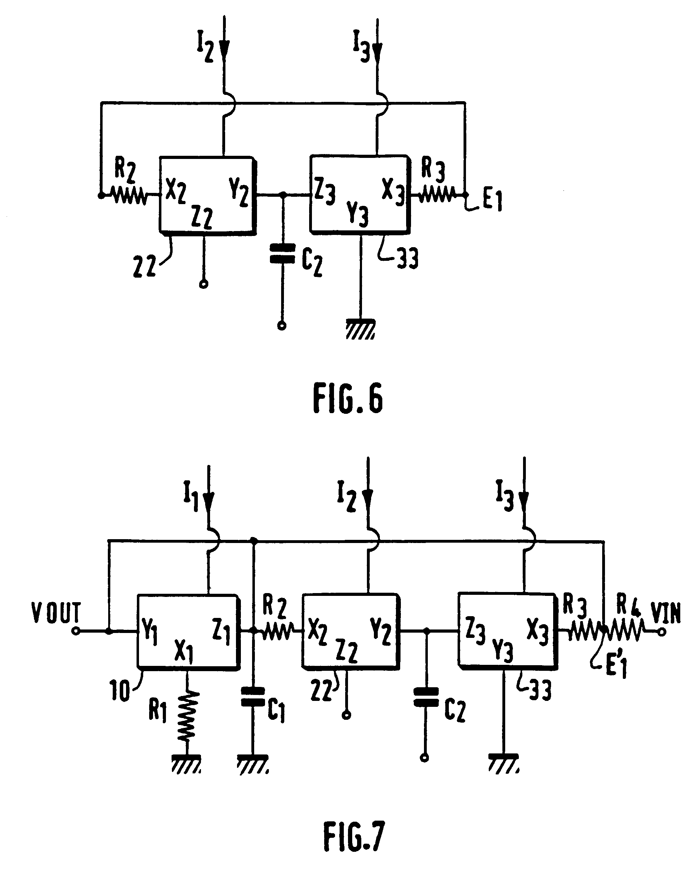

En référence maintenant à la figure 6, le circuit électronique représenté constitue un circuit de simulation de self.

Il comprend un deuxième 22 et un troisième 33 convoyeur de courant de deuxième génération du même type que le premier convoyeur 10 décrit précédemment.

Dans l'exemple de réalisation représenté, le port de référence Y2 du deuxième convoyeur 22 peut être relié à la masse, par l'intermédiaire d'un deuxième condensateur C2, notamment s'il n'est pas utilisé en sortie et/ou connecté à un dispositif d'impédance faible par rapport à la masse, et le port de sortie Z2 peut notamment, s'il n'est pas utilisé en sortie et/ou connecté à un dispositif d'impédance faible par rapport à la masse, être relié à la masse.

Le troisième convoyeur 33 voit son port de sortie Z3 relié au port de référence Y2 du deuxième convoyeur 22, tandis que son port de référence Y3 est relié à la masse.

La borne d'entrée E1 du circuit de simulation de self est constituée par le point de connexion entre le port d'entrée X2 du deuxième convoyeur de courant et le port d'entrée X3 du troisième convoyeur de courant.

Il est évident que le circuit de simulation met en évidence une configuration particulière des deux convoyeurs qui le constituent, mais que ces convoyeurs peuvent présenter d'autres configurations par application des permutations des ports X-Y ou X-Z à l'un et/ou à l'autre des convoyeurs, chaque convoyeur pouvant être de type CCII+ ou CCII-.

Ainsi, l'un quelconque des ports d'entrée X2 ou de référence Y2 du deuxième convoyeur est relié à l'un quelconque des ports d'entrée X3 ou de sortie Z3 du troisième convoyeur et la borne d'entrée EI du circuit de simulation de self est constituée par le point de connexion entre l'un quelconque des ports d'entrée X2 ou de sortie Z2 du deuxième convoyeur et l'un quelconque des ports d'entrée X3 ou de référence Y3 du troisième convoyeur.

En référence maintenant à la figure 7, le circuit électronique représenté constitue un filtre passe-bande réglable et comprend trois convoyeurs de courant dont le premier, référencé 10, réalise une résistance négative comme précédemment indiqué en référence à la figure 3b. Ainsi, ce premier convoyeur 10 voit son port de sortie $Z_1$ relié au port de référence $Y_1$ tandis que son port d'entrée $X_1$ est relié à la masse. Le port de sortie $Z_1$ du premier convoyeur 10 est par ailleurs relié à la masse par l'intermédiaire d'un premier condensateur $C_1$.

Ce filtre passe-bande comporte en outre deux autres convoyeurs de courant 22, 23 qui réalisent un circuit de simulation de self tel que décrit précédemment en référence à la figure 6.

L'entrée EI du circuit de simulation de self est alors reliée d'une part au port de sortie $Z_1$ du premier convoyeur 10, et d'autre part à une borne d'une résistance R4 dont l'autre borne constitue une borne libre du circuit formant passe-bande.

Selon un premier mode de réalisation, le filtre passe-bande est en mode tension. Ainsi, l'entrée du circuit est constituée par la borne libre de la résistance R4 à laquelle est appliquée une tension d'entrée Vin, tandis que la sortie du circuit est constituée par le port de référence $Y_1$ du premier convoyeur 10 sur lequel est prélevée une tension de sortie Vout.

Selon un deuxième mode de réalisation, le filtre passe-bande est en mode courant. Dans ce cas, l'entrée du circuit est constituée par le port d'entrée $Y_1$ du premier convoyeur 10 auquel est appliqué un courant d'entrée Iin, et la sortie du circuit est constituée par la borne libre de la résistance R4 sur laquelle est prélevé un courant de sortie Iout.

Si l'on se réfère maintenant à la figure 8, le circuit électronique représenté est un filtre passe-bande en mode courant. Il comporte un quatrième convoyeur 44 qui a son port d'entrée X4 relié à la borne libre de la résistance R4, tandis que son port de référence Y4 est relié à la masse. Ce circuit présente donc une entrée qui est constituée par le port de référence $Y_1$ du premier convoyeur 10 et une sortie constituée par le port de sortie Z4 du quatrième convoyeur 44. Le courant d'entrée Iin est alors appliqué sur le port d'entrée $Y_1$ du premier convoyeur 10, alors que le courant de sortie Iout est prélevé sur le port de sortie Z4. Ce quatrième convoyeur 44 joue principalement le rôle d'un adaptateur d'impédance.

Les résistances R1, R2, R3 représentées sur le schéma des figures 6, 7 et 8 représentent essentiellement les résistances internes de chacun des convoyeurs correspondant, auxquelles peut être ajoutée si besoin est une résistance physique. On obtient ainsi, dans le cas de la figure 8, un filtre passe-bande du deuxième ordre dont les caractéristiques sont les suivantes :
fréquence centrale

$$W0 = 1 / \sqrt{(C1 \times C2 \times R2 \times R3)},$$

coefficient de qualité

$$Q = \sqrt{(C1/C2)} \times [1 /(1/R2 + 1/R3 + 1/R4 - 1/R1) \times \sqrt{(R2 \times R3)}]$$

et le gain G

$$G = 1 / [R4 (1/R2 + 1/R3 + 1/R4 - 1/R1)]$$

Chacune des résistances R1, R2, R3 et R4 étant constituée par au moins la valeur de la résistance interne de chaque convoyeur correspondant entre le port d'entrée et le port de référence, on obtient ainsi un filtre passe-bande dont tous les paramètres (fréquence, coefficient de qualité et gain) sont réglables à partir des courants de polarisation de chacun des convoyeurs.

Cette architecture de filtre permet d'obtenir d'autres types de filtres. Par exemple non limitatif, en utilisant le port de sortie $Z_2$ du convoyeur 22, on obtient une sortie passe-bas du deuxième ordre. De même, le courant délivré par la

borne du condensateur $C_1$ non reliée au port de sortie $Z_1$ du convoyeur 10 constitue une sortie passe-haut du deuxième ordre , tandis que le courant délivré par la borne du condensateur $C_2$ non reliée au port de référence $Y_2$ du deuxième convoyeur 22 constitue aussi une sortie passe-bande du deuxième ordre.

Bien que seuls certains modes de réalisation de l'invention aient été décrits, il est évident que toute modification apportée ne sortirait pas du cadre de la présente invention. Par exemple, tous les circuits proposés sont réalisables dans les technologies MOS, FET ASGA ou HBT ou par association de plusieurs technologies.

**Revendications**

1. Circuit électronique comprenant au moins un premier convoyeur de courant de deuxième génération (10) constitué par une boucle translinéaire mixte et une pluralité de miroirs de courant, le convoyeur (10) présentant un port de référence ($Y_1$) à haute impédance, un port d'entrée ($X_1$) ayant une résistance intrinsèque (R) équivalente à la résistance de sortie du générateur de Thévenin équivalent, vu par le port d'entrée ($X_1$) et étant polarisé par un courant de polarisation ($I_1$), un port de sortie (Z1) dont le courant correspond à celui du port d'entrée (X1), et des moyens de commande de l'intensité du courant de polarisation ($I_1$) pour déterminer la valeur ohmique de ladite résistance intrinsèque (R), caractérisé en ce que les ports de référence ($Y_1$) et de sortie ($Z_1$) sont directement reliés entre eux.

2. Circuit électronique selon la revendication 1, caractérisé en ce que l'un au moins des ports est relié à la masse.

3. Circuit électronique selon la revendication 1 ou 2, caractérisé en ce que ledit port d'entrée ($X_1$) est connecté à une source de courant (14) et au port de référence ($Y_2$) d'un deuxième convoyeur (20) de courant de deuxième génération similaire au premier convoyeur (10) dont le port d'entrée ($X_2$) est relié à la masse, de telle manière que le courant sur le port de sortie ($Z_2$) du deuxième convoyeur (20) soit égal au courant ($I_e$) délivré par ladite source de courant (14) multiplié par un coefficient multiplicateur fonction du rapport des courants de polarisation de chacun desdits convoyeurs (10, 20).

4. Circuit électronique selon la revendication 2, caractérisé en ce que ledit port d'entrée ($X_1$) est relié à la masse, le port de référence ($Y_1$) est connecté à une source de tension (15) et le port de sortie ($Z_1$) est connecté au port d'entrée ($X_2$) d'un deuxième convoyeur (20) de courant de deuxième génération comportant, outre un port de référence ($Y_2$) relié à la masse, un deuxième port d'entrée ($X_2$,) copiant la tension d'entrée du port d'entrée ($X_2$) de telle manière que la tension sur le port d'entrée ($X'_2$) du deuxième convoyeur soit égale à la tension ($V_{Y1}$) délivrée par la source de tension (15) multipliée par un coefficient fonction du rapport des courants de polarisation de chacun desdits convoyeurs (10, 20).

5. Circuit électronique selon la revendication 3, caractérisé en ce que le courant de polarisation ($I_2$) dudit deuxième convoyeur (20) et le courant ($I_e$) délivré par ladite source de courant (14) sont des courants alternatifs.

6. Circuit électronique formant circuit de simulation de self, comportant une borne d'entrée (EI) et une autre borne de mise à la masse, caractérisé en ce qu'il comporte, en outre, un deuxième (22) et un troisième (33) convoyeurs de courant de deuxième génération constitués respectivement par une boucle translinéaire mixte et une pluralité de miroirs de courant, les convoyeurs présentant respectivement un port de référence (Y2, Y3) à haute impédance, un port d'entrée (X2, X3) ayant une résistance intrinsèque (R) équivalente à la résistance de sortie du générateur de Thévenin équivalent, vu par le port d'entrée (X2, X3), et étant polarisé respectivement par un courant de polarisation (I2, I3), et un port de sortie (Z2, Z3) dont le courant correspond à celui du port d'entrée, et des moyens de commande de l'intensité des courants de polarisation (I2, I3) pour déterminer la valeur ohmique de ladite résistance intrinsèque (R), l'un quelconque des ports d'entrée (X2) ou de référence (Y2) du deuxième convoyeur (22) étant relié d'une part à une borne d'une capacité (C2) dont l'autre borne est reliée à la masse, et d'autre part, à l'un quelconque des ports d'entrée (X3) ou de sortie (Z3) du troisième convoyeur (33), et la borne d'entrée (EI) du circuit de simulation de self étant constitué par le point de connexion entre l'un quelconque des ports d'entrée (X2) ou de sortie (Z2) du deuxième convoyeur (22) et l'un quelconque des ports d'entrée (X3) ou de référence (Y3) du troisième convoyeur (33).

7. Circuit électronique selon la revendication 1 ou 2 et la revendication 6, caractérisé en ce que lesdits ports de sortie ($Z_1$) et de référence ($Y_1$) dudit premier convoyeur (10) sont reliés à la masse par l'intermédiaire d'un premier condensateur ($C_1$), tandis que le port d'entrée ($X_1$) est relié directement à la masse, et en ce que la borne d'entrée (E1) du circuit de simulation est reliée d'une part au point de connexion entre le premier condensateur (C1) et les ports de sortie (Z1) et de référence (Y$_1$) du premier convoyeur (10), et d'autre part à une borne d'une résistance R4, de manière à réaliser ainsi un filtre passe-bande dont les caractéristiques sont réglables par modification d'au moins un des courants de polarisation appliqués aux dits convoyeurs.

8. Circuit selon la revendication 7 caractérisé en ce que l'entrée du circuit est constituée par la borne libre de la résistance R4, à laquelle est appliquée une tension d'entrée (Vin), tandis que la sortie du circuit est constituée par le port de référence (Y$_1$) du premier convoyeur sur lequel est prélevée une tension de sortie (Vout), de manière à réaliser ainsi un filtre passe-bande en mode tension, dont les caractéristiques sont réglables par modification d'au moins un des courants de polarisation appliqués aux dits convoyeurs.

9. Circuit selon la revendication 7 caractérisé en ce que l'entrée du circuit est constituée par le port d'entrée (Y$_1$) du premier convoyeur (10) auquel est appliqué un courant d'entrée (Iin) et la sortie du circuit est constituée par la borne libre de la résistance (R4) sur laquelle est prélevé un courant de sortie (Iout), de manière à réaliser ainsi un filtre passe-bande en mode courant, dont les caractéristiques sont réglables par modification d'au moins un des courants de polarisation appliqués aux dits convoyeurs.

10. Circuit selon la revendication 7 caractérisé en ce qu'il comporte en outre un quatrième convoyeur (44) de courant de deuxième génération de même type que le premier convoyeur (10) dont le port d'entrée (X4) est relié à la borne libre de la résistance R4, le port de référence (Y4) est relié à la masse, la sortie du circuit étant constituée par le port de sortie (Z4) dudit quatrième convoyeur (44) sur lequel est prélevé un courant de sortie (Iout), tandis que l'entrée du circuit est constituée par le port d'entrée (Y$_1$) du premier convoyeur (10) auquel est appliqué un courant d'entrée (Iin), de manière à réaliser ainsi un filtre passe-bande en mode courant, dont les caractéristiques sont réglables par modification d'au moins un des courants de polarisation appliqués aux dits convoyeurs.

**Patentansprüche**

1. Elektronische Schaltung mit mindestens einem ersten Stromförderer der zweiten Generation (10), bestehend aus einer gemischten translinearen Schleife und mehreren Stromspiegeln, wobei der Förderer (10) einen Referenzanschluß (Y$_1$) mit hoher Impedanz aufweist, einen Eingangsanschluß (X$_1$) mit einer Eigenwiderstand (R) gleich dem Ausgangswiderstand des gleichwertigen Théveningenerators, vom Eingangsanschluß (X$_1$) aus gesehen, und mit Polung durch einen Polarisierungsstrom (I$_1$), einen Ausgangsanschluß (Z$_1$), dessen Strom demjenigen des Eingangsanschlusses (X$_1$) entspricht, und Steuermittel für die Polarisierungsstromstärke (I$_1$) zur Bestimmung des Ohmwerts des besagten Eigenwiderstands (R), dadurch gekennzeichnet, daß der Referenzanschluß (Y$_1$) und Ausgangsanschluß (Z$_1$) direkt miteinander verbunden sind.

2. Elektronische Schaltung nach Anspruch 1, dadurch gekennzeichnet, daß minstestens einer der Anschlüsse an die Masse angeschlossen ist.

3. Elektronische Schaltung nach Anspruch 1 oder 2, dadurch gekennzeichnet, daß der Eingangsanschluß (X$_1$) an eine Stromquelle (14) und an den Referenzanschluß (Y$_2$) eines dem ersten Förderer (10) ähnlichen zweiten Stromförderers (20) zweiter Generation angeschlossen ist, dessen Eingangsanschluß (X$_2$) an die Masse so angeschlossen ist, daß der Strom am Ausgangsanschluß (Z$_2$) des zweiten Förderers (20) gleich dem Strom (I$_e$) ist, der von der Stromquelle (14) geliefert wird, multipliziert mit einem Multiplikator, der vom Verhältnis der Polarisierungsströme jedes der Förderer (10, 20) abhängt.

4. Elektronische Schaltung nach Anspruch 2, dadurch gekennzeichnet, daß der Eingangsanschluß (X$_1$) an die Masse angeschlossen ist, der Refererenzanschluß (Y$_1$) an eine Spannungsquelle (15) angeschlossen ist und der Ausgangsanschluß (Z$_1$) an den Eingangsanschluß (X$_2$) eines zweiten Stromförderers (20) angeschlossen ist, der außer einen an die Masse angeschlossenen Referenzanschluß (Y$_2$), einen zweiten Eingangsanschluß (X$_2$,) ausweißt, der die Eingangsspannung des Eingangsanschlusses (X$_2$) so kopiert, daß die Spannung am Eingangsanschluß (X'$_2$) des zweiten Förderers gleich der Spannung (V$_{Y1}$) ist, die von der Spannungsquelle (15) geliefert wird, multipliziert mit einem Multiplikator, der vom Verhältnis der Polarisierungsströme jedes der besagten Förderer (10, 20) abhängt.

5. Elektronische Schaltung nach Anspruch 3, dadurch gekennzeichnet, daß der Polarisierungsstrom (I$_2$) des zweiten Förderers (20) und der von der besagten Stromquelle (14) gelieferte Strom (I$_e$) Wechselströme sind.

**6.** Elektronische Schaltung, die einen Drosselsimulationsschaltkreis bildet, der eine Eingangsklemme ($E_1$) und eine weitere Masseanschlußklemme umfaßt, dadurch gekennzeichnet, daß sie weiteren einen zweiten (22) und einen dritten (33) Stromförderer zweiter Generation umfaßt, die von einer translinearen Schleife bzw. mehreren Stromspiegeln gebildet werden, wobei die Förderer jeweils einen Referenzanschluß ($Y_2$, $Y_3$) mit hoher Impedanz bzw. einen Eingangsanschluß ($X_2$, $X_3$) haben, mit einem Eigenwiderstand (R) gleichwertig mit dem Ausgangswiderstand des gleichwertigen Théveningenerators, vom Eingangsanschluß ($X_2$, $X_3$) aus gesehen, und wobei der Eingangsauschluß von einem Polarisierungsstrom (I2, I3) und einem Ausgangsanschluß ($Z_2$, $Z_3$) polarisiert wird, dessen Strom demjenigen des Eingangsanschlusses entspricht, und Mittel zur Steuerung der Polarisierungsstromstärken (I2, I3), zur Bestimmung des Ohmwerts des Eigenwiderstands (R), wobei beliebig ein Eingangsanschluß ($X_2$) oder Referenzanschluß ($Y_2$) des zweiten Förderers (22) einerseits an eine Klemme mit einer Kapazität ($C_2$), deren andere Klemme an die Masse angeschlossen ist, und andererseits beliebig an einen Eingangsanschluß ($X_3$) oder Ausgangsanschluß ($Z_3$) angeschlossen ist, und daß die Eingangsklemme ($E_1$) des Drosselsimulationsschaltkreises aus dem Anschlußpunkt zwischen einem beliebigen Eingangsanschluß ($X_2$) oder einem Ausgangsanschluß ($Z_2$) des zweiten Förderers (22) und einem beliebigen Eingangsanschluß ($X_3$) oder Referenzanschluß ($Y_3$) des dritten Förderers (33) besteht.

**7.** Elektronische Schaltung nach Anspruch 1 oder 2 und Anspruch 6, dadurch gekennzeichnet, daß die Ausgangs- und Referenzanschlüsse ($Z_1$, $Y_1$) des ersten Förderers (10) vermittels eines ersten Kondensators ($C_1$) an die Masse angeschlossen sind, während der Eingangsanschluß ($X_1$) direkt an die Masse angeschlossen ist, und dadurch, daß die Eingangsklemme ($E_1$) des Simulationsschaltkreises einerseits mit dem Anschlußpunkt zwischen dem ersten Kondensator ($C_1$) und dem Ausgangsanschluß ($Z_1$) und dem Referenzanschluß ($Y_1$) des ersten Förderers (10) und andererseits an eine Klemme mit einem Widerstand ($R_4$) so verbunden ist, daß somit ein Bandfilter hergestellt wird, dessen Merkmale durch Änderung mindestens eines der Polarisierungsströme regelbar sind, die an den Förderern anliegen.

**8.** Schaltung nach Anspruch 7, dadurch gekennzeichnet, daß der Eingang der Schaltung von der freien Klemme des Widerstands ($R_4$) gebildet wird, an der eine Eingangsspannung ($V_{in}$) anliegt, während der Ausgang der Schaltung vom Referenzanschluß ($Y_1$) des ersten Förderers gebildet wird, von dem eine Ausgangsspannung ($V_{out}$) entnommen wird, sodaß somit ein Bandfilter im Spannungsmodus hergestellt wird, dessen Merkmale durch Änderung mindestens eines der Polarisierungsströme regelbar sind, die an den Förderern anliegen.

**9.** Schaltung nach Anspruch 7, dadurch gekennzeichnet, daß der Eingang der Schaltung vom Eingangsanschluß ($Y_1$) des ersten Förderers (10) gebildet wird, an dem ein Eingangsstrom ($I_{in}$) anliegt, und daß der Ausgang der Schaltung von der freien Klemme des Widerstands ($R_4$) gebildet wird, von dem ein Ausgangsstrom ($I_{out}$) entnommen wird, sodaß somit ein Bandfilter im Strommodus hergestellt wird, dessen Merkmale durch Änderung mindestens eines der Polarisierungsströme regelbar sind, die an den Förderern anliegen.

**10.** Schaltung nach Anspruch 7, dadurch gekennzeichnet, daß sie weiteren einen vierten Stromförderer (44) der zweiten Generation vom gleichen Typ wie der erste Förderer (10) umfaßt, dessen Eingangsanschluß ($X_4$) an die freie Klemme des Widerstands ($R_4$) angeschlossen ist, daß der Referenzanschluß ($Y_4$) an die Masse angeschlossen ist, wobei der Ausgang der Schaltung vom Ausgangsanschluß ($Z_4$) des vierten Förderers (44) gebildet wird, von dem ein Ausgangsstrom ($I_{out}$) entnommen wird, während der Eingang der Schaltung vom Eingangsanschluß ($Y_1$) des ersten Förderers (10) gebildet wird, an dem ein Eingangsstrom ($I_{in}$) anliegt, sodaß somit ein Bandfilter im Strommodus hergestellt wird, dessen Merkmale durch Änderung mindestens eines der Polarisierungsströme regelbar sind, die an den besagten Förderern anliegen.

## Claims

**1.** An electronic circuit comprising at least one first second-generation current conveyor (10) made up of a mixed translinear loop and a plurality of current mirrors, said conveyor (10) having a high-impedance reference port ($Y_1$), an input port ($X_1$) with an intrinsic resistance (R) equivalent to the output resistance of the equivalent Thevenin-type generator at said input port ($X_1$) and which is polarized by a polarization current ($I_1$), an output port (Z1) whose current corresponds to that of the input port (X1), and means to control the intensity of the polarization current ($I_1$), so as to determine the ohmic value of said intrinsic resistance (R), characterised in that the reference ($Y_1$) and output port ($Z_1$) are directly connected together.

**2.** An electronic circuit according to claim 1, characterised in that at least one of the ports is connected to ground.

**3.** An electronic circuit according to claim 1 or 2, characterised in that said input port ($X_1$) is connected to a source of current (14) and to the reference port ($Y_2$) of a second second-generation current conveyor (20) similar to the first conveyor (10), whose input port ($X_2$) is connected to ground in such a way that the current applied to the output port ($Z_2$) of the second conveyor (20) is equal to the current ($I_e$) delivered by said source of current (14) multiplied by a multiplying coefficient dependent on the ratio of the polarization currents of each of said conveyors (10, 20).

**4.** An electronic circuit according to claim 2, characterised in that said input port ($X_1$) is connected to ground, the reference port ($Y_1$) is connected to a voltage source (15), and the output port ($Z_1$) is connected to the input port ($X_2$) of a second second-generation current conveyor (20) including, in addition to a reference port ($Y_2$) connected to ground, a second input port ($X_{2'}$) which duplicates the input voltage of the input port ($X_2$) in such a way that the voltage at the input port ($X_{2'}$) of the second conveyor is equal to the voltage ($V_{Y_1}$) delivered by the source of voltage (15) multiplied by a coefficient dependent on the ratio of the polarization currents of each of said conveyors (10, 20).

**5.** An electronic circuit according to claim 3, characterised in that the polarization current ($I_2$) of said second conveyor (20) and the current ($I_e$) delivered by said source of current (14) are alternating currents

**6.** An electronic circuit making up a self-inductance simulation circuit, including an input terminal (EI) and another terminal connected to ground, characterised in that it further comprises a second (22) and third (33) second-generation current conveyors respectively made up of a mixed translinear loop and a plurality of current mirrors, the conveyors respectively having a high-impedance reference port (Y2, Y3), an input port (X2, X3) with an intrinsic resistance (R) equivalent to the output resistance of the equivalent Thevenin-type generator, at the input port (X2, X3), and being respectively polarized by a polarization current (I2, I3), and an output port (Z2, Z3) whose current corresponds to that of the input port, and means to control the intensity of the polarization currents (I2, I3) so as to determine the ohmic value of said intrinsic resistance (R), either one of the input (X2) or reference (Y2) port of the second conveyor (22) being connected, on the one hand, to one terminal of a capacitor (C2) whose other terminal is connected to ground and, on the other hand, to either one of the input (X3) or output (Z3) port of the third conveyor (33), and the input terminal (E1) of the self-inductance simulation circuit consisting of the connecting point between either one of the input (X2) or output (Z2) port of the second conveyor (22) and either one of the input (X3) or reference (Y3) port of the third conveyor (33).

**7.** An electronic circuit according to claim 1 or 2 and claim 6, characterised in that said output ($Z_1$) and reference ($Y_1$) ports of said first conveyor (10) are connected to ground via a first capacitor ($C_1$), while the input port ($X_1$) is directly connected to ground, and in that the input terminal (E1) of the simulation circuit is connected, on the one hand, to the connecting point between the first capacitor (C1) and the output ($Z_1$) and reference ($Y_1$) ports of the first conveyor (10) and, on the other hand, to a terminal of a resistor (R4), so as to thus embody a bandpass filter whose characteristics can be adjusted by modifying at least one of the polarization currents applied to said conveyors.

**8.** An electronic circuit according to claim 7, characterised in that the input of the circuit consists of the free terminal of the resistor (R4) to which an input voltage (Vin) is applied, while the output of the circuit consists of the reference port ($Y_1$) of the first conveyor from which an output voltage (Vout) is drawn, so as to thus embody a bandpass filter in voltage mode, whose characteristics can be adjusted by modifying at least one of the polarization currents applied to said conveyors.

**9.** An electronic circuit according to claim 7, characterised in that the input of the circuit consists of the input port ($Y_1$) of the first conveyor (10) to which an input current (Iin) is applied, and the output of the circuit consists of the free terminal of the resistor (R4) from which an output current (Iout) is drawn, so as to thus embody a bandpass filter in current mode, whose characteristics can be adjusted by modifying at least one of the polarization currents applied to said conveyors.

**10.** An electronic circuit according to claim 7, characterised in that it further comprises a fourth second-generation current conveyor (44) of the same type as the first conveyor (10), whose input port (X4) is connected to the free terminal of the resistor (R4), the reference port (Y4) being connected to ground, the output of the circuit consisting of the output port (Z4) of said fourth conveyor (44) from which an output current (Iout) is drawn, while the input of the circuit consists of the input port ($Y_1$) of the first conveyor (10) to which an input current (Iin) is applied, so as to thus embody a bandpass filter in current mode, whose characteristics can be adjusted by modifying at least one of the polarization currents applied to said conveyors.

EP 0 699 359 B1

FIG.1

FIG.2

11

$I_1$

$V_{Y_1}$   $Y_1$   $Z^{\pm}$

$X_1$

$V_{X_1}$

**FIG. 3a**

$I_1$

$V_{Y_1}$   $Y_1$   $Z_1$

$X_1$   $10$

$V_{X_1}$

**FIG. 3b**

$10$   $I_1$   $I_2$   $20$

$15$   $V_{Y_1}$   $A$   $Y_1$   $Z_1$   $16$   $X_2$   $X'_2$   $V_{X'_2}$

$X_1$   $B$

$V_{16}$   $Y_2$

**FIG. 5**

FIG.4

FIG. 8

EP 0 699 359 B1

FIG.6

FIG.7